Europäisches Patentamt

European Patent Office

Office européen des brevets

(11) Veröffentlichungsnummer: **0 405 009**

**A2**

## (12) EUROPÄISCHE PATENTANMELDUNG

(21) Anmeldenummer: 89115078.1

(22) Anmeldetag: **16.08.89**

(51) Int. Cl.⁵ **H02M 3/07, G11C 17/00**

(30) Priorität: **20.06.89 CH 2286/89**

(43) Veröffentlichungstag der Anmeldung:
**02.01.91 Patentblatt 91/01**

(84) Benannte Vertragsstaaten:
**CH DE FR GB IT LI NL**

(71) Anmelder: **Feller, Ernst**
**Schorenstrasse 72**
**CH-3645 Gwatt(CH)**

(72) Erfinder: **Feller, Ernst**
**Schorenstrasse 72**
**CH-3645 Gwatt(CH)**

(54) **Integrierter Spannnungsvervielfacher für eine niedrige Speisespannung.**

(57) Ein integrierter Spannungsvervielfacher für eine besonders tiefe Speisespannung (1,5V) wird beschrieben. Der Spannungsvervielfacher wird hauptsächlich in elektrisch lösch- und programmierbaren Datenspeichern (EEPROMs) zur Erzeugung der Programmierspannung (Vpp) eingesetzt.

Der Spannungsvervielfacher enthält eine beliebige Anzahl Vervielfacherstufen ( i ) mit einem Pumpkondensator (Ci). Während einer ersten Taktphase wird der Pumpkondensator (Ci) mit einem ersten Transistor (Pi) vom Typ PMOS und einem zweiten Transistor (Ni) vom Typ NMOS auf die primäre Speisespannung (Vdd - Vss) aufgeladen. Während einer zweiten Taktphase wird der Pumpkondensator (Ci) mit einem dritten Transistor (Si) vom Typ NMOS in Serie mit dem Pumpkondensator (Ci + 1) der nachfolgenden Vervielfacherstufe ( i + 1 ) geschaltet.

Fig.3

EP 0 405 009 A2

## INTEGRIERTER SPANNUNGSVERVIELFACHER FÜR EINE NIEDRIGE SPEISESPANNUNG

Einleitung und Definitionen

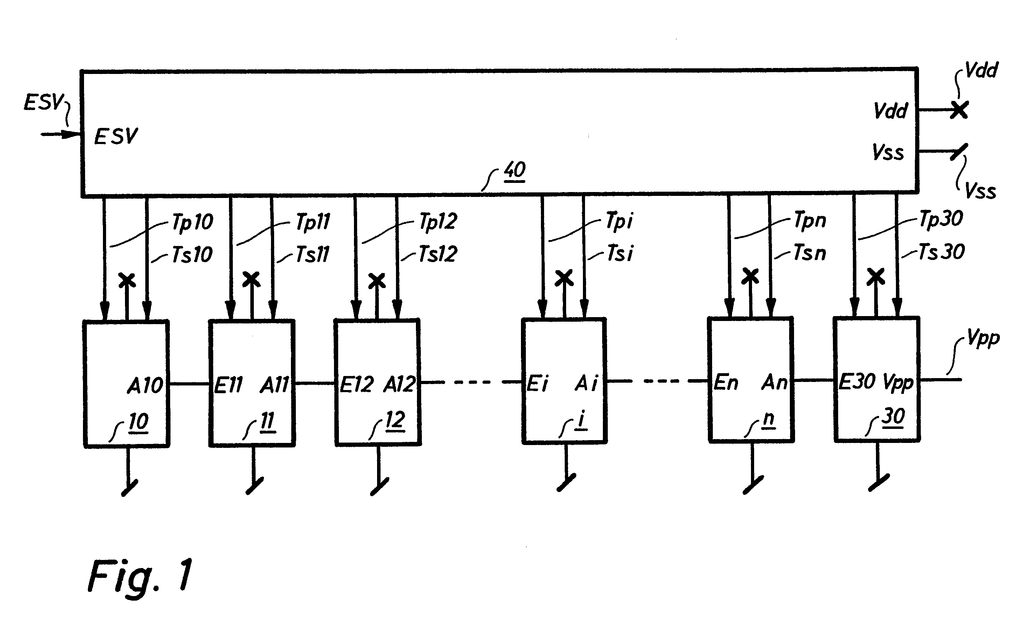

Ein Spannungsvervielfacher für integrierte Schaltungen, der aus der primären Speisespannung eine hohe sekundäre Gleichspannung erzeugt, ist dadurch gekennzeichnet, dass eine Anfangsstufe 10 , eine beliebige Anzahl Vervielfacherstufen 11 bis n und eine Auskoppelstufe 30 in Kette geschaltet sind und durch einen Taktgenerator 40 angesteuert werden (siehe Fig. 1).

Eine Vervielfacherstufe i ist dadurch gekennzeichnet, dass sie mit den Speiseleitungen Vdd und Vss verbunden ist, dass der Eingang Ei mit dem Ausgang Ai-1 der vorangehenden Vervielfacherstufe i-1 verbunden ist und dass ihr Ausgang Ai mit dem Eingang Ei + 1 der nachfolgenden Vervielfacherstufe i + 1 verbunden ist; zudem wird die Vervielfacherstufe i über mindestens eine der beiden Verbindungen Tpi oder Tsi vom Taktgenerator 40 angesteuert (siehe Fig. 1).

Die Anfangsstufe 10 ist dadurch gekennzeichnet, dass sie keinen Eingang E10 hat.

Die Auskoppelstufe 30 ist dadurch gekennzeichnet, dass sie mit dem Eingang E30 die hohe getaktete Spannung vom Ausgang An der letzten Vervielfacherstufe n übernimmt und am Ausgang Vpp eine hohe Gleichspannung Vdd - Vpp liefert.

Der Taktgenerator 40 mit den notwendigen logischen Funktionen zur Erzeugung der Taktsignale, ist dadurch gekennzeichnet, dass er mit den Speiseleitungen Vdd und Vss verbunden ist, an den Ausgängen Tp10 bis Tp30 und Ts10 bis Ts30 die geforderten periodischen Taktsignale in zeitlich richtig gestaffelter Folge liefert und die Funktion des Taktgenerators mit dem Eingang ESV ein- und ausgeschaltet werden kann (siehe Fig. 1).

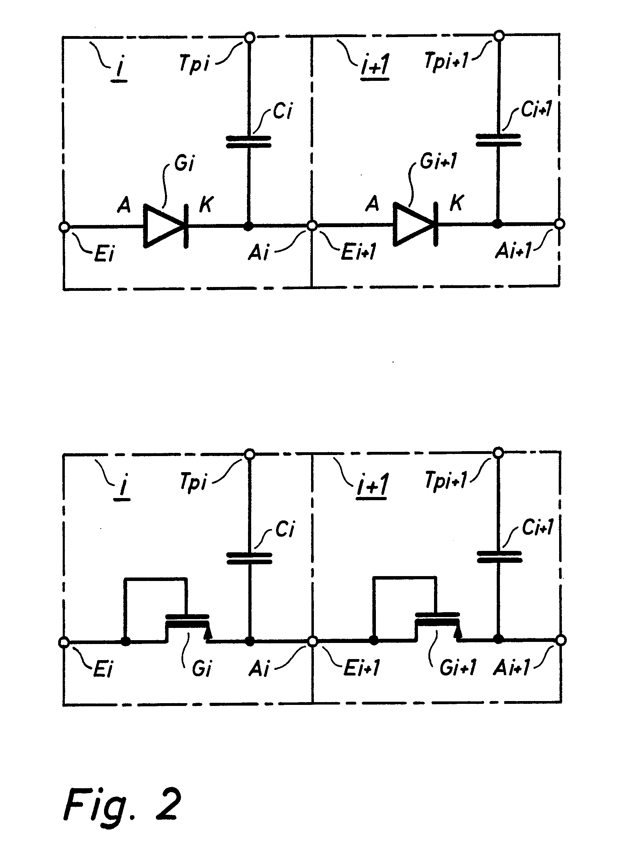

Die dem Stand der Technik angehörende Vervielfacherstufe i für integrierte Schaltungen ist gekennzeichnet durch ein Gleichrichterelement Gi, dessen Anode (bzw. Kathode) mit dem Eingang Ei und dessen Kathode (bzw. Anode) mit dem Ausgang Ai verbunden ist und durch einen Pumpkondensator Ci, der mit dem Ausgang Ai und mit dem Takteingang Tpi verbunden ist (siehe Fig. 2).

Die Gleichrichterelemente sind gekennzeichnet durch die Anwendung von Polysilizium-Dioden oder MOS-Transistoren bei welchen die Gate-Elektrode mit der Drain-Elektrode verbunden ist oder auch aufwendigere Schaltungen mit MOS-Transistoren.

Die Pumpkondensatoren sind gekennzeichnet durch die Anwendung von MOS-Kapazitäten (Poly-Silizium - Gate-Oxid - P-Well) oder Nitridkapazitäten (Aluminium -Nitrid - Poly-Silizium).

Solche Spannungsvervielfacher werden in elektrisch lösch- und programmierbaren nichtflüchtigen Datenspeichern (EEPROMs) angewendet.

Beschreibung der Erfindung (P-Well CMOS-Prozess)

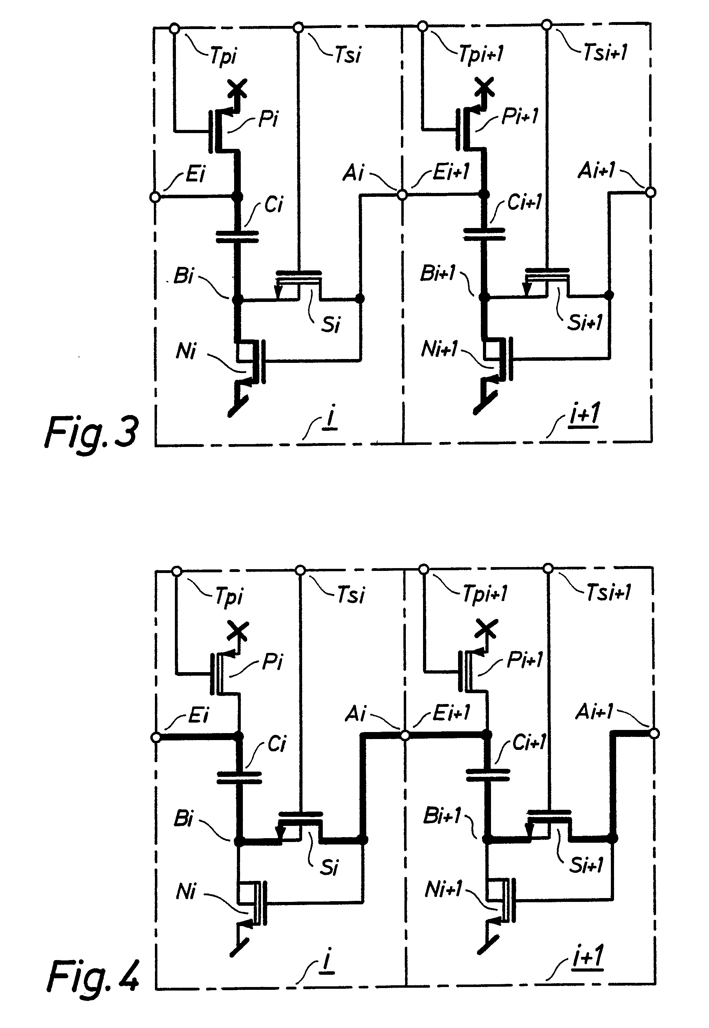

Die Vervielfacherstufe i eines Spannungsvervielfachers, hergestellt mit einem P-Well CMOS-Prozess, enthält einen Pumpkondensator Ci, welcher während einer ersten Taktphase (Tpi = 0, Tsi = 0) mit den Schalttransistoren Pi und Ni auf die Speisespannung Vdd - Vss aufgeladen wird (siehe Fig. 3).

Während der zweiten Taktphase (Tpi = 1, Tsi = 1) wird der Pumpkondensator Ci mit dem Schalttransistor Si in Serie mit dem Pumpkondensator Ci + 1 der nachfolgenden Stufe i + 1 geschaltet (siehe Fig. 4).

Die erste Taktphase wird eingeleitet indem das Taktsignal Tpi von 1 (Vdd) auf 0 (Vss) schaltet womit der Transistor Pi vom Typ PMOS einschaltet und den Eingang Ei auf Vdd-Potential zieht. Danach wird das Taktsignal Tsi von 1 auf 0 geschaltet womit der Transistor Si vom Typ NMOS ausschaltet und den Ausgang Ai freigibt. Schliesslich schaltet das Taktsignal Tpi + 1 von 1 auf 0 womit der Transistor Pi + 1 vom Typ PMOS einschaltet und den Ausgang Ai auf Vdd-Potential zieht; der Transistor Ni vom Typ NMOS wird eingeschaltet und der Pumpkondensator wird auf die Speisespannung Vdd - Vss aufgeladen.

Die zweite Taktphase wird eingeleitet indem das Taktsignal Tpi + 1 von 0 (Vss) auf 1 (Vdd) schaltet womit der Transistor Pi + 1 vom Typ PMOS ausschaltet und den Ausgang Ai freigibt. Anschliessend wird das Taktsignal Tsi von 0 auf 1 geschaltet womit der Transistor Si vom Typ NMOS einschaltet und den Ausgang Ai auf das Potential des Knotens Bi zieht; der Transistor Ni vom Typ NMOS wird gleichzeitig ausgeschaltet. Die Pumpkondensatoren Ci und Ci + 1 sind damit in Serie geschaltet; das P-Well der Transistoren Ni und Si ist mit dem Knoten Bi verbunden und hat damit automatisch das gewünschte tiefere Potential.

Die Vervielfacherstufe i ist dadurch gekennzeichnet, dass ein Pumpkondensator Ci während einer ersten Taktphase mit einem ersten Transistor Pi vom Typ PMOS und einem zweiten Transistor Ni vom Typ NMOS mit der primären Speisespannung aufgeladen wird und während einer zweiten Taktphase mit einem dritten Transistor Si vom Typ NMOS zwischen den Eingang Ei und den Ausgang Ai geschaltet wird (siehe Fig. 3 und 4).

Der Pumpkondensator Ci ist dadurch gekennzeichnet, dass die erste Elektrode mit dem Eingang Ei verbunden ist; die zweite Elektrode Bi ist mit der Source- und P-Well-Elektrode des zweiten Transistors Ni verbunden.

Der erste Transistor Pi vom Typ PMOS ist dadurch gekennzeichnet, dass die Drain-Elektrode mit dem Eingang Ei, die Gate-Elektrode mit dem ersten Takteingang Tpi und die Source- und Substrat-Elektrode mit der positiven Speiseleitung Vdd verbunden ist.

Der zweite Transistor Ni vom Typ NMOS ist dadurch gekennzeichnet, dass die Drain- und P-Well-Elektrode mit der zweiten Elektrode Bi des Pumpkondensators Ci, die Gate-Elektrode mit dem Ausgang Ai und die Source-Elektrode mit der negativen Speiseleitung Vss verbunden ist.

Der dritte Transistor Si vom Typ NMOS ist dadurch gekennzeichnet, dass die Source- und P-Well-Elektrode mit der zweiten Elektrode Bi des Pumpkondensators Ci, die Gate-Elektrode mit dem zweiten Takteingang Tsi und die Drain-Elektrode mit dem Ausgang Ai verbunden ist.

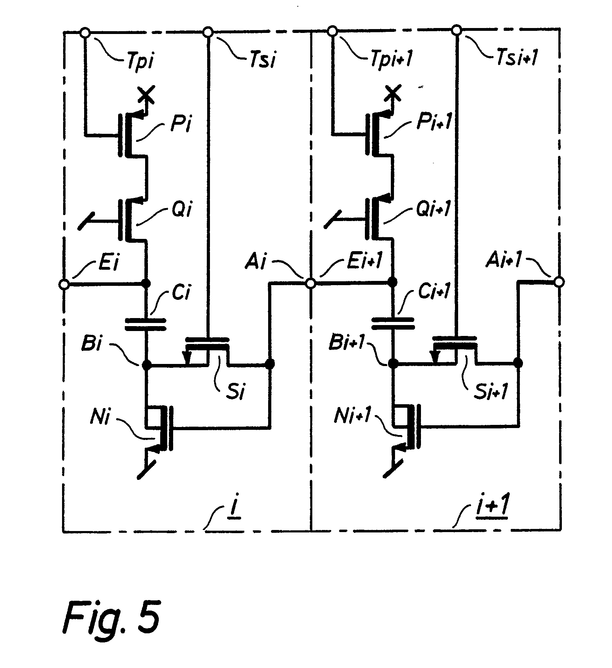

Die Vervielfacherstufe i für eine hohe Spannung und einen P-Well CMOS-Prozess ist dadurch gekennzeichnet, dass der erste Transistor Pi vom Typ PMOS durch eine Kaskodenschaltung von zwei Transistoren Pi und Qi ersetzt ist (siehe Fig. 5).

Der erste Transistor Pi ist dadurch gekennzeichnet, dass die Drain-Elektrode mit der Source-Elektrode des Kaskodentransistors Qi, die Gate-Elektrode mit dem ersten Takteingang Tpi, die Source- und Substrat-Elektrode mit der positiven Speiseleitung Vdd verbunden ist

Der Kaskodentransistor Qi ist dadurch gekennzeichnet, dass die Drain-Elektrode mit dem Eingang Ei der Vervielfacherstufe, die Gate-Elektrode mit der negativen Speiseleitung Vss, die Source-Elektrode mit der Drain-Elektrode des ersten Transistors Pi verbunden ist.

Der Taktgenerator 40 enthält in naheliegender Weise einen Ringoszillator, bestehend aus Bufferstufen mit einer geraden Anzahl in Kette geschalteter Inverter-Stufen und einem NAND-Gate G1, dessen erster Eingang mit dem Eingang ESV verbunden ist; die Phasen der Taktausgänge werden mit NAND-Gates vom Ringoszillator abgeleitet; der Taktgenerator ist dadurch gekennzeichnet, dass die Taktausgänge periodisch und zeitlich gestaffelt auf folgende Weise geschaltet werden:

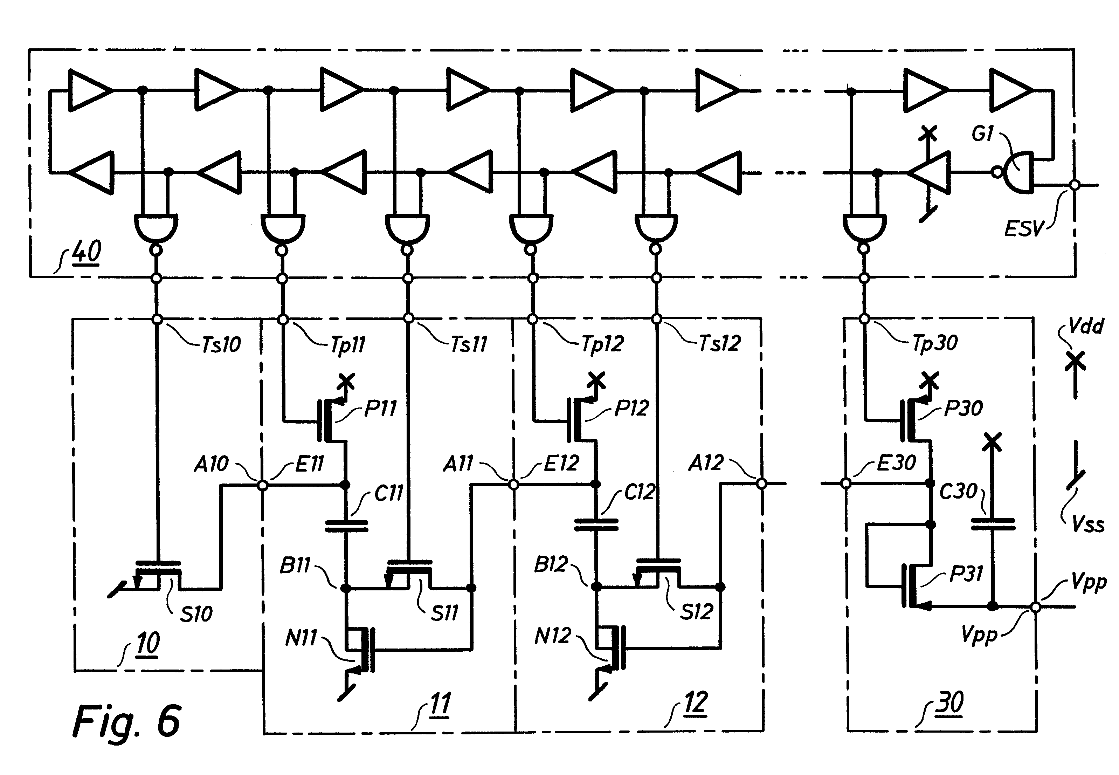

Beginnend mit Tp30 werden die Ausgänge Tp30, Tsn, Tpn, ... Tsi, Tpi, ... Ts11, Tp11 und Ts10 von 0 (Vss) auf 1 (Vdd) geschaltet und anschliessend rückwärts, beginnend mit Ts10, werden die Ausgänge Ts10, Tp11, Ts11, ... Tpi, Tsi, ... Tpn, Tsn und Tp30 wieder von 1 auf 0 geschaltet; der Taktgenerator ist ferner dadurch gekennzeichnet, dass im Ruhezustand, Eingang ESV = 0, alle Taktausgänge auf 0 stehen (siehe Fig. 6).

Die erste Vervielfacherstufe 10 ist dadurch gekennzeichnet, dass ein Transistor S10 vom Typ NMOS den Ausgang A10 während der zweiten Taktphase auf die negative Speiseleitung Vss schaltet. Der Transistor S10 ist dadurch gekennzeichnet, dass die Drain-Elektrode mit dem Ausgang A10, die Gate-Elektrode mit dem zweiten Takteingang Ts10 und die Source- und P-Well-Elektrode mit der negativen Speiseleitung Vss verbunden ist (siehe Fig. 6).

Die Auskoppelstufe 30 ist dadurch gekennzeichnet, dass ein erster Transistor P30 vom Typ PMOS zwischen den Eingang E30 und die positive Speiseleitung Vdd geschaltet ist und ein zweiter Transistor P31 vom Typ PMOS als Gleichrichterelement zwischen den Eingang E30 und den Ausgang Vpp geschaltet ist; zudem ist ein Glättungskondensator C30 zwischen den Ausgang Vpp und die positive Speiseleitung Vdd geschaltet (siehe Fig. 6).

Der erste Transistor P30 vom Typ PMOS ist dadurch gekennzeichnet, dass die Drain-Elektrode mit dem Eingang E30, die Gate-Elektrode mit dem ersten Takteingang Tp30 und die Source- und Substrat-Elektrode mit der positiven Speiseleitung Vdd verbunden ist.

Der zweite Transistor P31 vom Typ PMOS ist dadurch gekennzeichnet, dass die Source-Elektrode mit dem Ausgang Vpp, die Gate- und die Drain-Elektrode mit dem Eingang E30 verbunden ist.

Der Glättungskondensator C30 ist dadurch gekennzeichnet, dass die erste Elektrode mit dem Ausgang Vpp und die zweite Elektrode mit der positiven Speiseleitung Vdd verbunden ist.

Beschreibung der Erfindung (N-Well CMOS-Prozess)

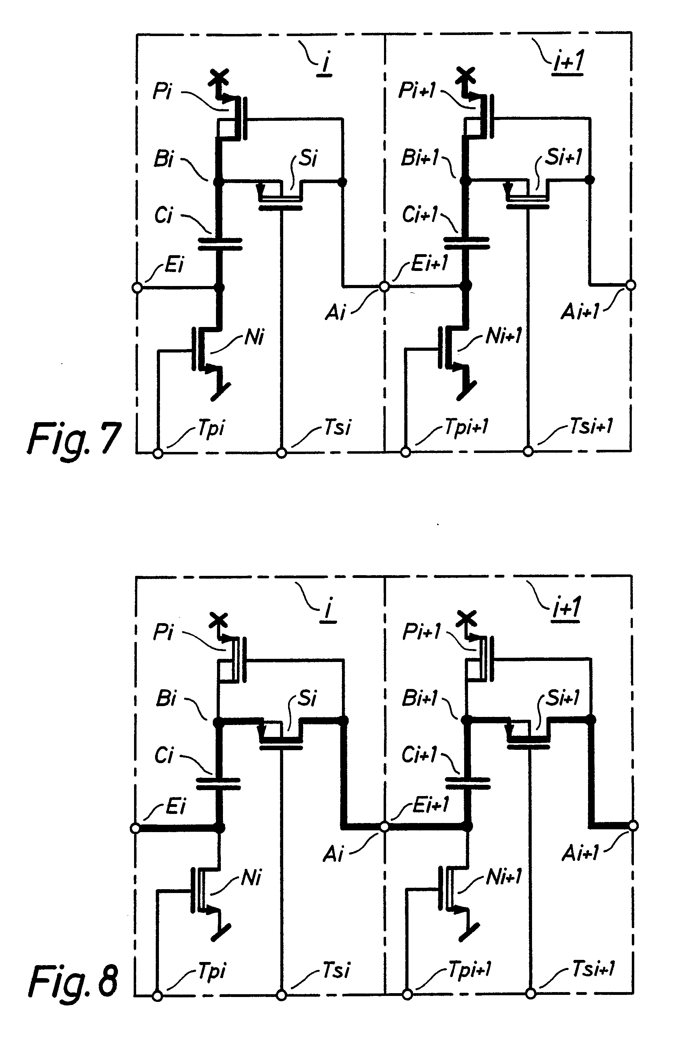

Die Vervielfacherstufe i eines Spannungsvervielfachers, hergestellt mit einem N-Well CMOS-Prozess, enthält einen Pumpkondensator Ci, welcher während einer ersten Taktphase (Tpi = 1, Tsi = 1) mit den Schalttransistoren Ni und Pi auf die Speisespannung Vdd - Vss aufgeladen wird (siehe Fig. 7).

Während der zweiten Taktphase (Tpi = 0, Tsi = 0) wird der Pumpkondensator Ci mit dem Schalttransistor Si in Serie mit dem Pumpkondensator Ci + 1 der nachfolgenden Stufe i + 1 geschaltet (siehe Fig. 8).

Die erste Taktphase wird eingeleitet indem das Taktsignal Tpi von 0 (Vss) auf 1 (Vdd) schaltet womit der Transistor Ni vom Typ NMOS einschaltet und den Eingang Ei auf Vss-Potential zieht. Danach wird das Taktsignal Tsi von 0 auf 1 geschaltet womit der Transistor Si vom Typ PMOS ausschaltet und den Ausgang Ai freigibt. Schliesslich schaltet das Taktsignal $Tpi+1$ von 0 auf 1 womit der Transistor $Ni+1$ vom Typ NMOS einschaltet und den Ausgang Ai auf Vss-Potential zieht; der Transistor Pi vom Typ PMOS wird eingeschaltet und der Pumpkondensator wird auf die Speisespannung Vdd - Vss aufgeladen.

Die zweite Taktphase wird eingeleitet indem das Taktsignal $Tpi+1$ von 1 (Vdd) auf 0 (Vss) schaltet womit der Transistor $Ni+1$ vom Typ NMOS ausschaltet und den Ausgang Ai freigibt. Anschliessend wird das Taktsignal Tsi von 1 auf 0 geschaltet womit der Transistor Si vom Typ PMOS einschaltet und den Ausgang Ai auf das Potential des Knotens Bi zieht; der Transistor Pi vom Typ PMOS wird gleichzeitig ausgeschaltet. Die Pumpkondensatoren Ci und $Ci+1$ sind damit in Serie geschaltet; das N-Well der Transistoren Pi und Si ist mit dem Knoten Bi verbunden und hat damit automatisch das gewünschte höhere Potential.

Die Vervielfacherstufe i ist dadurch gekennzeichnet, dass ein Pumpkondensator Ci während einer ersten Taktphase mit einem ersten Transistor Ni vom Typ NMOS und einem zweiten Transistor Pi vom Typ PMOS mit der primären Speisespannung aufgeladen wird und während einer zweiten Taktphase mit einem dritten Transistor Si vom Typ PMOS zwischen den Eingang Ei und den Ausgang Ai geschaltet wird (siehe Fig. 7 und 8).

Der Pumpkondensator Ci ist dadurch gekennzeichnet, dass die erste Elektrode mit dem Eingang Ei verbunden ist; die zweite Elektrode Bi ist mit der Source- und N-Well-Elektrode des zweiten Transistors Pi verbunden.

Der erste Transistor Ni vom Typ NMOS ist dadurch gekennzeichnet, dass die Drain-Elektrode mit dem Eingang Ei, die Gate-Elektrode mit dem ersten Takteingang Tpi und die Source- und Substrat-Elektrode mit der negativen Speiseleitung Vss verbunden ist.

Der zweite Transistor Pi vom Typ PMOS ist dadurch gekennzeichnet, dass die Drain- und N-Well-Elektrode mit der zweiten Elektrode Bi des Pumpkondensators Ci, die Gate-Elektrode mit dem Ausgang Ai und die Source-Elektrode mit der positiven Speiseleitung Vdd verbunden ist.

Der dritte Transistor Si vom Typ PMOS ist dadurch gekennzeichnet, dass die Source- und N-Well-Elektrode mit der zweiten Elektrode Bi des Pumpkondensators Ci, die Gate-Elektrode mit dem zweiten Takteingang Tsi und die Drain-Elektrode mit dem Ausgang Ai verbunden ist.

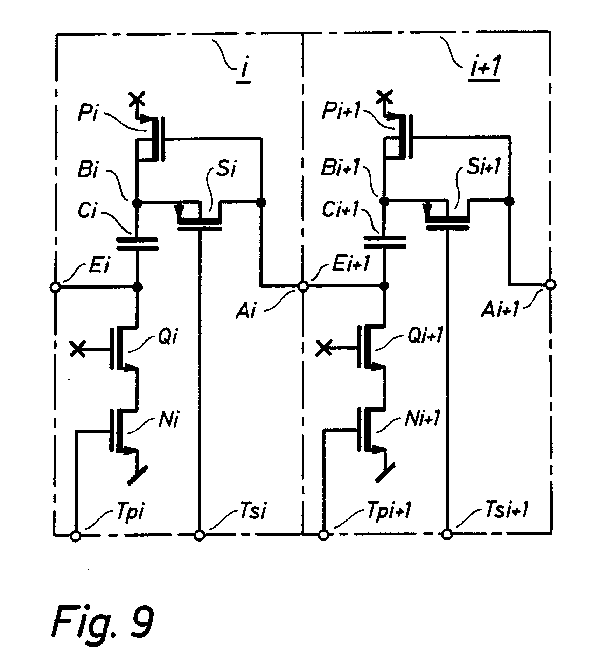

Die Vervielfacherstufe i für eine hohe Spannung und einen N-Well CMOS-Prozess ist dadurch gekennzeichnet, dass der erste Transistor Ni vom Typ NMOS durch eine Kaskodenschaltung von zwei Transistoren Ni und Qi ersetzt ist (siehe Fig. 9).

Der erste Transistor Ni ist dadurch gekennzeichnet, dass die Drain-Elektrode mit der Source-Elektrode des Kaskodentransistors Qi, die Gate-Elektrode mit dem ersten Takteingang Tpi, die Source- und Substrat-Elektrode mit der negativen Speiseleitung Vss verbunden ist.

Der Kaskodentransistor Qi ist dadurch gekennzeichnet, dass die Drain-Elektrode mit dem Eingang Ei der Vervielfacherstufe, die Gate-Elektrode mit der positiven Speiseleitung Vdd, die Source-Elektrode mit der Drain-Elektrode des ersten Transistors Ni verbunden ist.

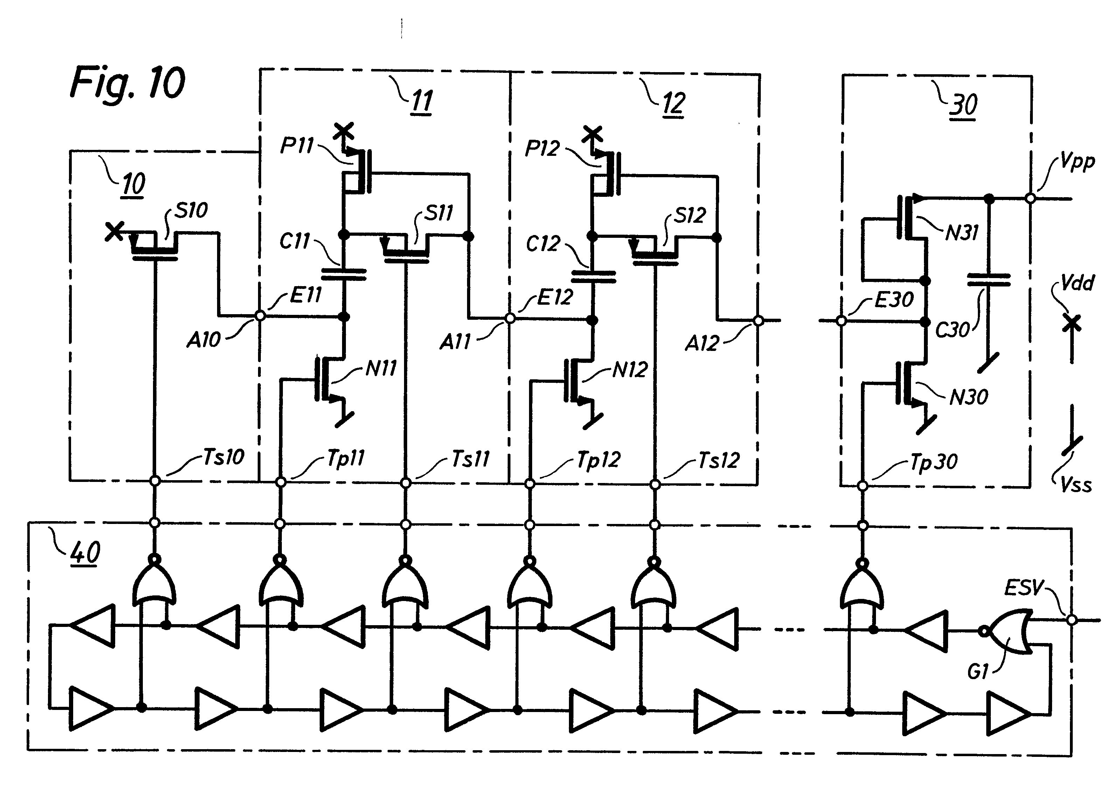

Der Taktgenerator 40 enthält in naheliegender Weise einen Ringoszillator, bestehend aus Bufferstufen mit einer geraden Anzahl in Kette geschalteter Inverte-r-Stufen und einem NOR-Gate G1, dessen erster Eingang mit dem Eingang ESV verbunden ist; die Phasen der Taktausgänge werden mit NOR-Gates vom Ringoszillator abgeleitet; der Taktgenerator ist dadurch gekennzeichnet, dass die Taktausgänge periodisch und zeitlich gestaffelt auf folgende Weise geschaltet werden:
Beginnend mit Tp30 werden die Ausgänge
Tp30, Tsn, Tpn, ... Tsi, Tpi, ... Ts11, Tp11 und Ts10 von 1 (Vdd) auf 0 (Vss) geschaltet und anschliessend rückwärts, beginnend mit Ts10, werden die Ausgänge Ts10, Tp11, Ts11, ... Tpi, Tsi, ... Tpn, Tsn und Tp30 wieder von 0 auf 1 geschaltet; der Taktgenerator ist ferner dadurch gekennzeichnet, dass im Ruhezustand, Eingang ESV = 1, alle Taktausgänge auf 1 stehen (siehe Fig. 10).

Die erste Vervielfacherstufe 10 ist dadurch gekennzeichnet, dass ein Transistor S10 vom Typ PMOS den Ausgang A10 während der zweiten Taktphase auf die positive Speiseleitung Vdd schaltet. Der Transistor S10 ist dadurch gekennzeichnet, dass die Drain-Elektrode mit dem Ausgang A10, die Gate-Elektrode mit dem zweiten Takteingang Ts10 und die Source- und N-Well-Elektrode mit der positiven Speiseleitung Vdd verbunden ist (siehe Fig. 10).

Die Auskoppelstufe 30 ist dadurch gekennzeichnet, dass ein erster Transistor N30 vom Typ NMOS zwischen den Eingang E30 und die negative Speiseleitung Vss geschaltet ist und ein zweiter Transistor N31 vom Typ NMOS als Gleichrichterelement zwischen den Eingang E30 und den Ausgang Vpp geschaltet ist; zudem ist ein Glättungskondensator C30 zwischen den Ausgang Vpp und die negative Speiseleitung Vss geschaltet (siehe Fig. 10).

Der erste Transistor N30 vom Typ NMOS ist dadurch gekennzeichnet, dass die Drain-Elektrode mit dem Eingang E30, die Gate-Elektrode mit dem ersten Takteingang Tp30 und die Source- und Substrat-Elektrode mit der negativen Speiseleitung Vss verbunden ist.

Der zweite Transistor N31 vom Typ NMOS ist dadurch gekennzeichnet, dass die Source-Elektrode mit dem Ausgang Vpp, die Gate- und die Drain-Elektrode mit dem Eingang E30 verbunden ist.

Der Glättungskondensator C30 ist dadurch gekennzeichnet, dass die erste Elektrode mit dem Ausgang Vpp und die zweite Elektrode mit der negativen Speiseleitung Vss verbunden ist.

Zeichnungen

1. In Figur 1 ist das Blockdiagramm eines Spannungsvervielfachers dargestellt.

2. In Figur 2 ist eine konventionelle Vervielfacherstufe mit einem PMOS-Transistor als Gleichrichterelement dargestellt.

3. In Figur 3 sind zwei Vervielfacherstufen für einen P-Well CMOS-Prozess während der ersten Taktphase dargestellt. Leitende Pfade sind fett gezeichnet.

4. In Figur 4 sind zwei Vervielfacherstufen für einen P-Well CMOS-Prozess während der zweiten Taktphase dargestellt. Leitende Pfade sind fett gezeichnet.

5. In Figur 5 ist die Vervielfacherstufe für eine hohe Spannung und einen P-Well CMOS-Prozess dargestellt.

6. In Figur 6 ist das Schema eines Spannungsvervielfachers für einen P-Well CMOS-Prozess mit einem Ausführungsbeispiel eines Taktgenerators dargestellt.

7. In Figur 7 sind zwei Vervielfacherstufen für einen N-Well CMOS-Prozess während der ersten Taktphase dargestellt. Leitende Pfade sind fett gezeichnet.

8. In Figur 8 sind zwei Vervielfacherstufen für einen N-Well CMOS-Prozess während der zweiten Taktphase dargestellt. Leitende Pfade sind fett gezeichnet.

9. In Figur 9 ist die Vervielfacherstufe für eine hohe Spannung und einen N-Well CMOS-Prozess dargestellt.

10. In Figur 10 ist das Schema eines Spannungsvervielfachers für einen N-Well CMOS-Prozess mit einem Ausführungsbeispiel eines Taktgenerators dargestellt.

Ansprüche

1. Ein integrierter Spannungsvervielfacher, hergestellt mit einem P-Well CMOS-Prozess, dadurch gekennzeichnet, dass die Vervielfacherstufe ( i ) einen Pumpkondensator (Ci) enthält, welcher während einer ersten Taktphase mit einem ersten Transistor (Pi) vom Typ PMOS und einem zweiten Transistor (Ni) vom Typ NMOS mit der primären Speisespannung aufgeladen wird und während einer zweiten Taktphase mit einem dritten Transistor (Si) vom Typ NMOS zwischen den Eingang (Ei) und den Ausgang (Ai) geschaltet wird.

Der Pumpkondensator (Ci) ist dadurch gekennzeichnet, dass die erste Elektrode mit dem Eingang (Ei) verbunden ist; die zweite Elektrode (Bi) ist mit der Source- und P-Well-Elektrode des zweiten Transistors (Ni) verbunden.

Der erste Transistor (Pi) vom Typ PMOS ist dadurch gekennzeichnet, dass die Drain-Elektrode mit dem Eingang (Ei), die Gate-Elektrode mit dem ersten Takteingang (Tpi) und die Source- und Substrat-Elektrode mit der positiven Speiseleitung (Vdd) verbunden ist.

Der zweite Transistor (Ni) vom Typ NMOS ist dadurch gekennzeichnet, dass die Drain- und P-Well-Elektrode mit der zweiten Elektrode (Bi) des Pumpkondensators (Ci), die Gate-Elektrode mit dem Ausgang (Ai) und die Source-Elektrode mit der negativen Speiseleitung (Vss) verbunden ist.

Der dritte Transistor (Si) vom Typ NMOS ist dadurch gekennzeichnet, dass die Source- und P-Well-Elektrode mit der zweiten Elektrode (Bi) des Pumpkondensators (Ci), die Gate-Elektrode mit dem zweiten Takteingang (Tsi) und die Drain-Elektrode mit dem Ausgang (Ai) verbunden ist.

2. Ein integrierter Spannungsvervielfacher, hergestellt mit einem N-Well CMOS-Prozess, dadurch gekennzeichnet, dass die Vervielfacherstufe ( i ) einen Pumpkondensator (Ci) enthält, welcher während einer ersten Taktphase mit einem ersten Transistor (Ni) vom Typ NMOS und einem zweiten Transistor (Pi) vom Typ PMOS mit der primären Speisespannung aufgeladen wird und während einer zweiten Taktphase mit einem dritten Transistor (Si) vom Typ PMOS zwischen den Eingang (Ei) und den Ausgang (Ai) geschaltet wird.

Der Pumpkondensator (Ci) ist dadurch gekennzeichnet, dass die erste Elektrode mit dem Eingang (Ei) verbunden ist; die zweite Elektrode (Bi) ist mit der Source- und N-Well-Elektrode des zweiten Transistors (Pi) verbunden.

Der erste Transistor (Ni) vom Typ NMOS ist dadurch gekennzeichnet, dass die Drain-Elektrode mit dem Eingang (Ei), die Gate-Elektrode mit dem ersten Takteingang (Tpi) und die Source- und Substrat-Elektrode mit der negativen Speiseleitung (Vss) verbunden ist.

Der zweite Transistor (Pi) vom Typ PMOS ist dadurch gekennzeichnet, dass die Drain- und N-Well-Elektrode mit der zweiten Elektrode (Bi) des Pumpkondensators (Ci), die Gate-Elektrode mit dem Ausgang (Ai) und die Source-Elektrode mit der positiven Speiseleitung (Vdd) verbunden ist.

Der dritte Transistor (Si) vom Typ PMOS ist dadurch gekennzeichnet, dass die Source- und N-Well-Elektrode mit der zweiten Elektrode (Bi) des Pumpkondensators (Ci), die Gate-Elektrode mit dem zweiten Takteingang (Tsi) und die Drain-Elektrode mit dem Ausgang (Ai) verbunden ist.

3. Ein Spannungsvervielfacher gemäss Anspruch 1 für eine hohe Ausgangsspannung, dadurch gekennzeichnet, dass die Vervielfacherstufe ( i ) anstelle des ersten Transistors (Pi) eine Kaskodenschaltung von zwei Transistoren (Pi und Qi) enthält. Die Drain-Elektrode des Kaskodentransistors (Qi) ist mit dem Eingang (Ei) der Vervielfacherstufe, die Gate-Elektrode mit der negativen Speiseleitung (Vss), die Source-Elektrode mit der DrainElektrode des ersten Transistors (Pi) verbunden.

4. Ein Spannungsvervielfacher gemäss Anspruch 2 für eine hohe Ausgangsspannung, dadurch gekennzeichnet, dass die Vervielfacherstufe ( i ) anstelle des ersten Transistors (Ni) eine Kaskodenschaltung von zwei Transistoren (Ni und Qi) enthält. Die Drain-Elektrode des Kaskodentransistors (Qi) ist mit dem Eingang (Ei) der Vervielfacherstufe, die Gate-Elektrode mit der positiven Speiseleitung (Vdd), die Source-Elektrode mit der Drain-Elektrode des ersten Transistors (Ni) verbunden.

5. Ein Spannungsvervielfacher gemäss Anspruch 1 und 2 für höhere Ströme, dadurch gekennzeichnet, dass alle Schaltelemente der Vervielfacherstufen in diskreter Bauweise ausgeführt sind.

6. Ein Spannungsvervielfacher gemäss Anspruch 1, 2, 3 und 4, der am Ausgang (Vpp) eine getaktete Spannung zur Ansteuerung einer Gasentladungsanzeige liefert, dadurch gekennzeichnet, dass in der Auskoppelstufe ( 30 ) das Gleichrichterelement (P31 bzw. N31) und der Glättungskondensator (C30) fehlen und der Eingang (E30) der Auskoppelstufe mit ihrem Ausgang (Vpp) verbunden ist.

Fig. 1

EP 0 405 009 A2

Fig. 2

Fig.3

Fig.4

Fig. 5

Fig. 6

Fig. 7

Fig. 8

Fig. 9

Fig. 10